# EUROPÄISCHE PATENTSCHRIFT

(11) **EP 4 275 062 B1**
(45) Veröffentlichungstag und Bekanntmachung des Hinweises auf die Patenterteilung: **19.06.2024**
(21) Anmeldenummer: 22764334.3
(22) Anmeldetag: 05.08.2022
(51) Int. Cl.: G01R 33/30, G01R 33/31, G01N 24/08

(54) **ÜBERWACHUNGSVORRICHTUNG ZUR TEMPERIERTEN KAPILLARFÜHRUNG MIT INEINANDER VERSCHACHTELTEN SCHLÄUCHEN UND TRANSPORTKAPILLAREN FÜR NMR-DURCHFLUSSZELLEN**
MONITORING DEVICE FOR TEMPERATURE-CONTROLLED CAPILLARY GUIDANCE WITH INTERLEAVED TUBES AND TRANSPORT CAPILLARIES FOR NMR FLOW CELLS
DISPOSITIF DE SURVEILLANCE POUR GUIDAGE CAPILLAIRE À TEMPÉRATURE CONTRÔLÉE AVEC TUBES IMBRIQUÉS ET CAPILLAIRES DE TRANSPORT POUR CELLULES D'ÉCOULEMENT RMN

(30) Priorität: 29.10.2021 DE 202021105945 U
(43) Veröffentlichungstag der Anmeldung: 15.11.2023
(73) Patentinhaber: Bruker Switzerland AG, 8117 Fällanden (CH)
(72) Erfinder: MEISTER, Roger, 8132 Hinteregg (CH)
(74) Vertreter: Kohler Schmid Möbus Patentanwälte
(86) Internationale Anmeldenummer: PCT/EP2022/072071
(87) Internationale Veröffentlichungsnummer: WO 2023/072449

(56) Entgegenhaltungen:
- EP-B1- 1 116 044
- EP-B1- 2 407 796
- DE-B3-102015 206 030
- BRÄCHER A ET AL: "Thermostatted micro-reactor NMR probe head for monitoring fast reactions", JOURNAL OF MAGNETIC RESONANCE, Bd. 242, 1. März 2014 (2014-03-01), Seiten 155-161, XP028643427, ISSN: 1090-7807, DOI: 10.1016/J.JMR.2014.02.013

## Beschreibung

Die Erfindung betrifft eine Überwachungsvorrichtung zum Durchführen einer Messung einer in einem Reaktionsbehälter erzeugten Reaktionsflüssigkeit in einem NMR-Spektrometer, insbesondere zur Kontrolle einer chemischen Reaktion mittels NMR-Spektroskopie, wobei die Überwachungsvorrichtung mindestens folgende Bauteile aufweist:
eine hohle NMR-Probensonde für die Aufnahme der im NMR-Spektrometer zu vermessenden Reaktionsflüssigkeit;
eine Einlasstransportkapillare zur Aufnahme der Reaktionsflüssigkeit aus dem Reaktionsbehälter und für den Transport der Reaktionsflüssigkeit von dem Reaktionsbehälter über eine Pumpeinrichtung hin zur Probensonde;
eine Auslasstransportkapillare für den Rücktransport der Reaktionsflüssigkeit von der Probensonde zum Reaktionsbehälter;
eine Einrichtung zum Leiten von Temperierfluid um die Einlass- und Auslasstransportkapillaren herum,
wobei die Einrichtung zum Leiten von Temperierfluid um die Einlass- und Auslasstransportkapillaren herum Schlauchabschnitte aufweist, die jeweils doppelwandig aus zwei ineinander verschachtelt angeordneten, radial jeweils geschlossenen Teilschläuchen mit einem äußeren Teilschlauch und einem inneren Teilschlauch aufgebaut sind, wobei zwischen dem äußeren und dem inneren Teilschlauch das Temperierfluid fließt und radial innerhalb des inneren Teilschlauchs die Einlasstransportkapillare oder die Auslasstransportkapillare angeordnet ist.

Eine solche Überwachungsvorrichtung ist aus der Druckschrift FOLEY, David A., et al. "NMR flow tube for online NMR reaction monitoring" Analytical chemistry, 2024, 86. Jg., Nr. 24, S.12008-12013 (=Referenz [0]) bekannt geworden.

### Hintergrund der Erfindung

Die vorliegende Erfindung befasst sich ganz allgemein mit dem Bereich der Kernspinresonanz (nuclear magnetic resonance = "NMR"), insbesondere mit Überwachungsvorrichtungen zum Durchführen von NMR-Messungen von Reaktionsflüssigkeiten in Echtzeit unter temperaturkontrollierten Bedingungen.

Die NMR-Spektroskopie ist ein in der instrumentellen Analytik weitverbreitetes und leistungsfähiges Verfahren. Mit Hilfe der NMR-Spektroskopie kann bei einer zu untersuchenden Substanz, wie beispielsweise einem Kohlenwasserstoff oder einer bio-anorganischen Komplexverbindung, die elektronische Umgebung einzelner Atome und der Wechselwirkung der einzelnen Atome mit den benachbarten Atomen untersucht werden. Auf diese Weise können zum Beispiel die Zusammensetzung, Struktur und Dynamik der zu untersuchenden Substanz aufgeklärt und ebenfalls die Konzentration der zu untersuchenden Substanz bestimmt werden.

Typischerweise wird bei der Messung von Substanzen in flüssiger Form die zu untersuchende Substanz in ein NMR-Röhrchen gefüllt. Das gefüllte NMR-Röhrchen wird zur Messung in den Messbereich eines NMR-Probenkopfs eines NMR-Spektrometers platziert. Die Substanz ist dort einem starken statischen, homogenen Magnetfeld B₀ ausgesetzt, wodurch die Kernspins in der Substanz ausgerichtet werden. In die zu untersuchende Substanz werden dann hochfrequente elektromagnetische Impulse eingestrahlt. Die hierbei erzeugten, ebenfalls hochfrequenten elektromagnetischen Felder werden im NMR-Spektrometer detektiert. Daraus können dann Informationen über die Eigenschaften der untersuchten Substanz gewonnen werden.

Messungen von Substanzen in flüssiger Form können als Einzelmessungen erfolgen, bei denen die Substanzen einzeln in die NMR-Röhrchen eingefüllt, gemessen und wieder entfernt werden. Von besonderem Interesse sind aber auch Anwendungen mit sogenannten NMR-Flusszellen ("NMR-flowcells").

Mit Hilfe von NMR-Flusszellen können chemische Reaktionen in Echtzeit und unter Reaktionsbedingungen beobachtet werden. Hierzu wird die zu untersuchende Substanz ("Reaktionsflüssigkeit") von einem Reaktionsbehälter, in dem die Reaktionsflüssigkeit in der Regel erzeugt wird, schnell und kontinuierlich zu einer hohlen NMR-Probensonde und durch die hohle NMR-Probensonde hindurch geleitet. Die NMR-Probensonde befindet sich in einem NMR-Spektrometer. Während die Reaktionsflüssigkeit durch die NMR-Probensonde geleitet wird, erfolgen gleichzeitig NMR-Messungen. Auf diese Weise wird eine kontinuierliche Überwachung der Reaktionsflüssigkeit (und damit des Reaktionsablaufs im Reaktionsbehälter) durch die NMR-Messungen erreicht.

Bei Anwendungen im Bereich der NMR-Flusszellen werden typischerweise Kapillaren für die Förderung der zu untersuchenden Substanz ("Messmedium") verwendet. Die Kapillaren sind meistens aus Kunststoff gefertigt und haben einen Außendurchmesser von 1/16" (≈0,16 cm) oder 1/32" (≈0,08 cm). Häufig ist das gesamte System so aufgebaut, dass das Messmedium von einem Reaktor ("Reaktionsbehälter") zu einer Pumpe gefördert wird. Von der Pumpe wird es dann weiter zum NMR-Messgerät und von da aus wieder zurück zum Reaktor geleitet.

Im Reaktor herrscht bei der Messung meistens eine bestimmte Temperatur. Hierdurch soll unter anderem sichergestellt werden, dass die chemischen Reaktionen im Reaktionsbehälter gleichmäßig und kontrolliert ablaufen und die folgenden NMR-Messungen miteinander vergleichbar sind. Damit diese bestimmte Temperatur für das Messmedium auf seinem Weg möglichst konstant bleibt, können die Kapillaren zumindest teilweise temperiert werden.

Bei Hochfeldsystemen findet beispielsweise das System "InsightMR" der Bruker Corporation, Billerica, Massachusetts, USA (=Referenz [3]) Anwendung. In diesem System wird der Kapillarbereich zwischen Pumpe und NMR-System und zwischen NMR-System und Reaktor temperiert. Die Temperierung erfolgt jedoch nicht auf der gesamten Länge. Weiterhin ist der Abschnitt zwischen Reaktor und Pumpe komplett untemperiert. Der temperierte Bereich, in dem die Kapillare geführt wird, ist als ein isolierter Schlauch ausgebildet. Das Temperiermedium umströmt in diesem isolierten Schlauch die Kapillare direkt.

Nachteilig an diesem System ist, dass es speziell für Hochfeldsysteme entwickelt worden ist und auch nur in dieser Anwendung gut funktioniert. Eine Adaption auf verschiedene Systeme und Umgebungen in anderen Bereichen ist nicht möglich. Weiterhin können keine Teilstücke verwendet werden, in denen die Kapillare temperiert geführt werden kann. Ebenso ist ein einfaches Austauschen der Kapillare, beispielsweise im Falle einer Verstopfung, nicht möglich. Es muss erst die Temperierflüssigkeit aus dem gesamten isolierten Schlauch abgelassen werden, bevor die Kapillare ausgetauscht werden kann.

Die EP 2 407 796 B1 (=Referenz [2]) beschreibt eine Überwachungszelle, mit der Messungen einer in einem Reaktionsbehälter erzeugten Reaktionsflüssigkeit in einem NMR-Spektrometer durchgeführt werden können. Die Überwachungszelle umfasst eine hohle NMR-Probensonde und ein Gehäuse mit einer Einlasstransportkapillare zur Aufnahme der Reaktionsflüssigkeit aus dem Reaktionsbehälter sowie eine Auslasstransportkapillare zum Abführen der Reaktionsflüssigkeit zurück in den Reaktionsbehälter. Weiterhin umfasst das Gehäuse der Überwachungszelle eine Einrichtung zum Leiten von Kühlflüssigkeit um die Einlasstransportkapillare und die Auslasstransportkapillare herum. Die Einlasstransportkapillare und die Auslasstransportkapillare werden durch einen Hohlraum geführt. Der Hohlraum ist mit der Einrichtung zum Leiten von Kühlflüssigkeit verbunden. Während einer Messung wird der Hohlraum mit Kühlflüssigkeit durchströmt.

Kommt es beispielsweise zu einer Verstopfung einer der Kapillaren, muss wiederum zuerst die gesamte Kühlflüssigkeit abgelassen werden, damit danach dann die verstopfte Kapillare entfernt werden kann. Bei einem Leck oder einer Beschädigung der Kapillare kann zusätzlich noch Reaktionsflüssigkeit austreten und die Kühlflüssigkeit kontaminieren. Dies kann eine aufwändige Reinigung der Einrichtung zum Leiten von Kühlflüssigkeit erforderlich machen und zu einer mitunter teuren Entsorgung der kontaminierten Kühlflüssigkeit führen. Weiterhin ist die Einrichtung zum Leiten der Kühlflüssigkeit speziell auf dieses System ausgelegt und kann nicht auf andere Systeme angepasst werden.

Die DE 10 2015 206 030 B3 (=Referenz [1]) stellt ebenfalls eine Überwachungszelle vor, mit der Messungen einer in einem Reaktionsbehälter erzeugten Reaktionsflüssigkeit in einem NMR-Spektrometer durchgeführt werden können. Ähnlich wie in Referenz [2] beschrieben, umfasst die Überwachungszelle eine hohle NMR-Probensonde und ein Gehäuse mit einer Einlasstransportkapillare zur Aufnahme der Reaktionsflüssigkeit aus dem Reaktionsbehälter und eine Auslasstransportkapillare zum Abführen der Reaktionsflüssigkeit zurück in den Reaktionsbehälter. Weiterhin umfasst das Gehäuse der Überwachungszelle eine Einrichtung zum Leiten von Temperierfluid mit einer Zuleitung und mit einer Ableitung für das Temperierfluid in die Überwachungszelle. Die Transportkapillaren sind innerhalb der Zuleitung des Temperierfluids geführt und die Zuleitung ist koaxial von der Ableitung umgeben. Während einer Messung stehen die Transportkapillaren also auch hier in direktem Kontakt zum Temperierfluid.

Kommt es beispielsweise zu einer Verstopfung einer der Kapillaren, muss bei dieser Überwachungszelle ebenfalls zuerst das Temperiermedium abgelassen werden, damit die verstopfte Kapillare entfernt werden kann. Bei einem Leck oder einer Beschädigung der Kapillare kann auch hier zusätzlich noch Reaktionsflüssigkeit austreten und das Temperierfluid kontaminieren. Dies kann wiederum eine aufwändige Reinigung der Einrichtung zum Leiten von Temperierfluid nach sich ziehen und zu einer mitunter teuren Entsorgung des kontaminierten Temperierfluids führen. Weiterhin ist die Einrichtung zum Leiten des Temperierfluids auch hier speziell auf dieses System ausgelegt und kann nicht auf andere Systeme angepasst werden.

Die eingangs zitierte Referenz [0] beschreibt eine für die vorliegende Erfindung generische Überwachungszelle mit sämtlichen im 1. Absatz der obigen ersten Beschreibungsseite definierten Merkmalskomplexen. Diese Überwachungszelle wird wiederum im Durchfluss betrieben ("NMR Flow Tube for Online NMR Reaction Monitoring"). Allerdings fließt hier die Temperierflüssigkeit nicht nur in eine einzige Richtung, sondern wird in drei koaxialen Schläuchen hin und wieder zurück befördert. Damit kann keine wirklich gleichmäßige Temperierung der flüssigen NMR-Probe auf der gesamten Transportstrecke vom Reaktionsbehälter in das NMR-Spektrometer und wieder zurück sichergestellt werden.

### Aufgabe der Erfindung

Der vorliegenden Erfindung liegt demgegenüber die Aufgabe zugrunde, bei einer Überwachungsvorrichtung der eingangs beschriebenen Art zum Durchführen einer Messung einer in einem Reaktionsbehälter erzeugten Reaktionsflüssigkeit in einem NMR-Spektrometer mit unaufwändigen technischen Mitteln die Einrichtung zum Leiten von Temperierfluid um die Einlass- und Auslasstransportkapillaren herum so auszugestalten, dass die Einlass- und Auslasstransportkapillaren zu jedem Zeitpunkt problemlos getauscht werden können, dass die Einrichtung zum Leiten von Temperierfluid universell auch in anderen Einsatz-Umgebungen einsetzbar ist, und dass während des Betriebs die Einlass- und Auslasstransportkapillaren stets und vollständig gleichmäßig temperiert werden.

### Kurze Beschreibung der Erfindung

Diese Aufgabe wird durch die vorliegende Erfindung auf ebenso überraschend einfache wie wirkungsvolle Weise dadurch gelöst, dass die Überwachungsvorrichtung einen geschlossenen Temperierkreislauf für das Temperierfluid aufweist, welcher geometrisch derart ausgestaltet ist, dass das Temperierfluid in jedem räumlichen Bereich des Temperierkreislaufs immer nur in eine vorgegebene Richtung fließt und keine gegenläufige Strömung des Temperierfluids in unmittelbarer Nachbarschaft des räumlichen Bereichs auftritt.

Die vorliegende Erfindung schlägt also vor, anstelle eines Transports der flüssigen NMR-Probe in drei koaxialen Schläuchen vom Reaktionsbehälter in das NMR-Spektrometer und wieder zurück, wie in Referenz [0] offenbart, stattdessen die Einrichtung derart zu modifizieren, dass an jedem Punkt der Einrichtung die Reaktionsflüssigkeit und auch das Temperierfluid immer nur in einer einzigen Flussrichtung fließen. Dies gelingt durch die erfindungsgemäße Konstruktion eines Kühlmittel-Kreislaufs, dessen Schläuche zudem radial auch noch deutlich kompakter und technisch unaufwändiger aufgebaut sind als die in Referenz [0] vorgeschlagenen Dreifach-Schläuche. Die erfindungsgemäße Kreislaufführung der Flüssigkeiten impliziert eine räumliche Trennung des vom Reaktionsbehälter zum NMR-Spektrometer hinfließenden Temperierfluids von dem vom NMR-Spektrometer zum Reaktionsbehälter zurückfließenden Temperierfluids. Damit kann nunmehr eine vollständig gleichmäßige Temperierung der Reaktionsflüssigkeit auf der gesamten Transportstrecke sichergestellt werden.

Es wird zudem eine strikte Trennung zwischen den Einlass- und Auslasstransportkapillaren ("Transportkapillaren") und dem Temperierfluid eingerichtet. Hierzu werden doppelwandige Schlauchabschnitte eingerichtet, die jeweils aus einem äußeren Teilschlauch und einem inneren Teilschlauch, der im Inneren des äußeren Teilschlauchs angeordnet ist, aufgebaut sind. In einem Zwischenbereich zwischen dem äußeren Teilschlauch und dem inneren Teilschlauch fließt das Temperierfluid. Innerhalb des inneren Teilschlauchs fließt kein Temperierfluid. Die Transportkapillaren sind innerhalb des inneren Teilschlauchs angeordnet, der frei von Temperierfluid ist.

Durch diese erfindungsgemäße Ausgestaltung können die Transportkapillaren auf einfache Weise und zeitsparend in den doppelwandigen Schlauchabschnitt eingeführt oder entfernt werden, beispielsweise durch einfaches Hineindrücken der jeweiligen Transportkapillare in den inneren Teilschlauch. Das bisher zumeist erforderliche umständliche Auseinanderbauen und Zusammenbauen der Einrichtung zum Leiten von Temperierfluid entfällt.

Aufgrund der räumlichen Separierung des Temperierfluids durch die bauliche Ausgestaltung der doppelwandigen Schlauchabschnitte und der Transportkapillaren kann die Einrichtung zum Leiten von Temperierfluid äußerst flexibel eingesetzt werden. Anders gesagt kann die erfindungsgemäß ausgestaltete Einrichtung zum Leiten von Temperierfluid für ganz unterschiedliche bauliche Situationen der Überwachungsvorrichtung genutzt werden und ist nicht auf einen besonderen, speziellen Aufbau beschränkt.

Tritt während einer Messung der Reaktionsflüssigkeit ein Problem an einer Transportkapillare auf, beispielsweise eine Verstopfung oder eine Beschädigung der Transportkapillare, kann diese ganz einfach zügig aus dem inneren Teilschlauch herausgezogen werden. Insbesondere muss das Temperierfluid nicht erst abgelassen werden, bevor die entsprechende Transportkapillare entfernt werden kann. Die Transportkapillare kann also problemlos entfernt werden, während weiterhin Temperierfluid im Zwischenbereich zwischen dem äußeren Teilschlauch und dem inneren Teilschlauch fließt. Verunreinigungen im inneren Teilschlauch können auf einfache Weise sehr effektiv beispielsweise mittels Durchleiten eines Lösemittels durch den inneren Bereich des inneren Teilschlauchs entfernt werden.

Durch die räumliche Trennung von Temperierfluid und Transportkapillare kann bei einer Beschädigung der Transportkapillare wirksam verhindert werden, dass das Temperierfluid durch ein Leck mit der Reaktionsflüssigkeit in Kontakt kommt. Die Gefahr einer unerwünschten Reaktion des Temperierfluids mit der Reaktionsflüssigkeit kann somit ausgeschlossen werden. Ebenso kann eine Kontamination zwischen dem Temperierfluid und der Reaktionsflüssigkeit verhindert werden. Einer oft kostenintensiven Entsorgung des kontaminierten Temperierfluids und/oder der kontaminierten Reaktionsflüssigkeit wird in dieser Weise entgegengewirkt.

Bei der Nutzung mehrerer Transportkapillaren in der Einrichtung zum Leiten von Temperierfluid während einer Messung können bei Problemen einer Transportkapillare, die einen Tausch der entsprechenden Transportkapillare nach sich zieht, die verbleibenden Transportkapillaren weiterhin temperiert werden. Die Messung der Reaktionsflüssigkeit in den verbleibenden Transportkapillaren kann ohne Unterbrechung einfach fortgesetzt werden.

Bei dem inneren Teilschlauch und dem äußeren Teilschlauch handelt es sich jeweils um radial geschlossene Teilschläuche. Die Transportkapillaren sind innerhalb des inneren Teilschlauchs radial angeordnet. Aufgrund der Form-Gleichheit zwischen dem radial inneren Teilschlauch und der innerhalb des inneren Teilschlauchs radial angeordneten Transportkapillare kann eine effektive und gleichmäßige Temperierung der Transportkapillare (und damit der Reaktionsflüssigkeit) mit dem Temperierfluid erreicht werden. Die Effektivität der Temperierung kann weiter gesteigert werden, indem der Abstand zwischen dem inneren Teilschlauch und der Transportkapillare verringert wird.

Die Schlauchabschnitte können aus einem chemisch inertem Kunststoff, beispielsweise PTFE, aufgebaut sein. Hierdurch kann bei einem Leck einer Transportkapillare verhindert werden, dass der entsprechende Schlauchabschnitt Schäden durch die austretende Reaktionsflüssigkeit nimmt.

Als Temperierfluid kann entsprechend des für die Reaktionsflüssigkeit nötigen Temperaturbereichs z. B. vollentsalztes Wasser (VE Wasser), 2-Propanol (Isopropanol) oder ein Temperieröl verwendet werden. Das Temperierfluid kann mittels einer Temperierfluidpumpe ("Fluidpumpe") durch die Einrichtung zum Leiten von Temperierfluid geleitet werden.

### Bevorzugte Ausführungsformen und Weiterbildungen der Erfindung

Bei ganz besonders bevorzugten Ausführungsformen der erfindungsgemäßen Überwachungsvorrichtung ist vorgesehen, dass die inneren Teilschläuche konzentrisch zu den äußeren Teilschläuchen angeordnet sind.

Diese Anordnung kann einfach umgesetzt und in der Praxis eingerichtet werden. Durch die gleichmäßige Beabstandung zwischen den inneren Teilschläuchen und den äußeren Teilschläuchen in radialer Richtung kann sich das Temperierfluid gleichmäßig in einem Zwischenraum zwischen den inneren Teilschläuchen und den äußeren Teilschläuchen verteilen. Eine gleichmäßige Temperierung der Einlass- und Auslasstransportkapillaren kann so ermöglicht werden.

Eine bevorzugte Klasse von Ausführungsformen der erfindungsgemäßen Überwachungsvorrichtung ist dadurch gekennzeichnet, dass die inneren Teilschläuche geometrisch derart ausgebildet sind, dass die Einlasstransportkapillare und die Auslasstransportkapillare in die inneren Teilschläuche eingeführt und auch wieder aus ihnen herausgezogen werden können.

Hierdurch können die Einlasstransportkapillare und die Auslasstransportkapillare schnell und unkompliziert ausgetauscht werden, beispielsweise bei einer Verstopfung oder Beschädigung der entsprechenden Kapillare. Die Einrichtung zum Leiten von Temperierfluid muss also nicht erst zeitintensiv auseinander gebaut werden, damit die entsprechende Kapillare ausgetauscht werden kann.

Bei bevorzugten Weiterbildungen dieser Klasse von Ausführungsformen sind die Innendurchmesser der inneren Teilschläuche größer oder gleich den Außendurchmessern der entsprechenden Einlasstransportkapillare beziehungsweise der entsprechenden Auslasstransportkapillare gestaltet. Bei einem Innendurchmesser der inneren Teilschläuche, der größer ist als der Außendurchmesser der entsprechenden Einlasstransportkapillare beziehungsweise der entsprechenden Auslasstransportkapillare, können die entsprechende Einlasstransportkapillare beziehungsweise die entsprechende Auslasstransportkapillare komfortabel in die inneren Teilschläuche eingeführt werden. Bei einem Innendurchmesser der inneren Teilschläuche, der ungefähr gleich dem Außendurchmesser der entsprechenden Einlasstransportkapillare beziehungsweise der entsprechenden Auslasstransportkapillare ist, können die entsprechende Einlasstransportkapillare beziehungsweise die entsprechende Auslasstransportkapillare bündig schließend in den inneren Teilschläuchen angeordnet werden. Die inneren Teilschläuche und die entsprechende Einlasstransportkapillare beziehungsweise die entsprechende Auslasstransportkapillare liegen direkt aneinander an, wodurch die Temperatur des Temperierfluids gut übertragen werden kann. Weiterhin kann ein Verrutschen der entsprechenden Einlasstransportkapillare beziehungsweise der entsprechenden Auslasstransportkapillare erschwert werden.

Weiterhin bevorzugt sind Weiterentwicklungen dieser Weiterbildungen, die sich dadurch auskennzeichnen, dass zumindest die inneren Teilschläuche aus einem Material mit Gleitwerkstoffen mit Reibungskoeffizienten µ ≤ 1, vorzugsweise µ ≤ 0,1, insbesondere µ ≤ 0,05, und/oder einem dehnbaren Material aufgebaut sind.

Hierdurch können die entsprechende Einlasstransportkapillare beziehungsweise die entsprechende Auslasstransportkapillare besonders einfach und komfortabel reibungsarm in die inneren Teilschläuche eingeführt werden. Bei inneren Teilschläuchen aus einem dehnbaren Material können die entsprechenden Transportkapillaren unter Dehnung des dehnbaren Materials in die inneren Teilschläuche eingeführt werden. Außerdem kann sich das dehnbare Material eng um die die entsprechenden Transportkapillaren legen. Die Temperatur des Temperierfluids kann dann verlustarm auf die entsprechenden Transportkapillaren übertragen werden und die Transportkapillaren können stabil in Position gehalten werden.

Ebenso bevorzugt ist eine Klasse von Ausführungsformen, bei denen die doppelwandigen Schlauchabschnitte der Einrichtung zum Leiten von Temperierfluid um die Einlass- und Auslasstransportkapillaren herum als Baukasten-System aufgebaut sind, welches auf verschiedene Benutzer-Anforderungen, NMR-Spektrometer und Umgebungen adaptiert werden kann, und in welchem die doppelwandigen Schlauchabschnitte als jeweils eigenständige, insbesondere austauschbare Einheiten vorhanden sind.

Hier sind die doppelwandigen Schlauchabschnitte als Baukasten-System aufgebaut, vielseitig einsetzbar und bieten eine hohe Flexibilität für unterschiedliche Situationen. Eine zeitintensive Umgestaltung der Einrichtung zum Leiten von Temperierfluid entfällt. Dadurch, dass die doppelwandigen Schlauchabschnitte als eigenständige Einheiten ausgebildet sind, können diese auf einfache Weise ersetzt werden, beispielsweise bei einer Beschädigung oder einem Leck der doppelwandigen Schlauchabschnitte. Mit Hilfe dieser eigenständigen Einheiten können sowohl Kosten gespart als auch eine zeitintensive Wartung vermieden werden.

Weiterhin bevorzugt sind Weiterentwicklungen dieser Klasse von Ausführungsformen, bei denen die doppelwandigen Schlauchabschnitte als abgeschlossene Einheiten einer jeweils vorbestimmten Länge, insbesondere mit einer Länge von 2m, ausgeführt sind.

Auf diese Weise können die doppelwandigen Schlauchabschnitte standardisiert und in großer Menge produziert werden. Der Austausch von doppelwandigen Schlauchabschnitten kann somit enorm vereinfacht werden. Die Einrichtung zum Leiten von Temperierfluid bleibt auch nach dem Austausch nahezu unverändert.

Besonders bevorzugt sind auch Ausführungsformen der erfindungsgemäßen Überwachungsvorrichtung, bei denen die Einrichtung zum Leiten von Temperierfluid um die Einlass- und Auslasstransportkapillaren herum Endstücke zum Anschluss der doppelwandigen Schlauchabschnitte an eine Fluidpumpe umfasst.

Dies kann leicht in die Praxis umgesetzt werden: Die Endstücke und damit die doppelwandigen Schlauchabschnitte können auf einfache Weise mit der Pumpeinrichtung verbunden werden und über die Pumpeinrichtung kann das Temperierfluid für die doppelwandigen Schlauchabschnitte zur Verfügung gestellt werden. Die Endstücke können außerdem die Stabilität der Einrichtung zum Leiten von Temperierfluid verbessern.

Bei bevorzugten Weiterbildungen dieser Ausführungsformen sind zumindest ein Teil der Endstücke als Mehrfachvarianten zur gleichzeitigen Aufnahme von mehreren Einlass- oder Auslasstransportkapillaren für unterschiedliche Reaktionsflüssigkeiten ausgebildet.

Diese Endstücke sind also so ausgebildet, dass durch die Einlass- oder Auslasstransportkapillaren mehrere Reaktionsflüssigkeiten gleichzeitig durch die Einrichtung zum Leiten von Temperierfluid geführt werden können. Es können dann die mehreren Reaktionsflüssigkeiten beispielsweise simultan oder kurz hintereinander in die hohle NMR-Probensonde geführt und vermessen werden. Dadurch lassen sich Zeit und Kosten einsparen. Weiterhin besteht die Möglichkeit, neue und baulich abweichende Versuchsaufbauten in einfacher Weise zu gestalten.

Bevorzugt sind auch Weiterentwicklungen dieser Weiterbildungen, die sich dadurch auszeichnen, dass das Mehrfachvarianten-Endstück so ausgebildet ist, dass es mehrere, vorzugsweise drei, Einlass- oder Auslasstransportkapillaren aufnehmen kann, jedoch nur einen doppelwandigen Schlauchabschnitt, mit dem sämtliche aufgenommenen Kapillaren über einen mäanderförmig durch das Mehrfachvarianten-Endstück verlaufenden Temperierkanal gleichzeitig temperiert werden können.

Durch die Möglichkeit, mehrere Einlass- oder Transportkapillaren im Mehrfachvarianten-Endstück aufnehmen zu können, können gleichzeitig verschiedene, temperierte Reaktionsflüssigkeiten in die hohle NMR-Probensonde geführt und aus der hohlen NMR-Probensonde abgeführt werden. Durch die Verwendung von nur einem doppelwandigen Schlauchabschnitt kann eine gleichmäßige Temperierung sämtlicher aufgenommener Kapillaren erreicht werden. Der doppelwandige Schlauchabschnitt ist so ausgestaltet, dass er die mehreren Einlass- oder Auslasstransportkapillaren problemlos aufnehmen kann.

Ebenfalls bevorzugt ist bei diesen Weiterentwicklungen vorgesehen, dass das Mehrfachvarianten-Endstück zwei einander gegenüberliegende Endabschnitte aufweist, die zur Aufnahme von jeweils zwei unterschiedlichen Kapillaren sowie zum Anschluss jeweils eines doppelwandigen Schlauchabschnitts ausgebildet sind, dass mindestens zwei einander jeweils gegenüberliegende Zwischenabschnitte vorgesehen sind, in welche nur jeweils eine Kapillare eingeführt werden kann, und dass die Endabschnitte mit den Zwischenabschnitten derart verbunden sind, dass der an den jeweiligen Endabschnitt angeschlossene doppelwandige Schlauchabschnitt an einem dem Endabschnitt unmittelbar benachbart angeordneten Zwischenabschnitt angeschlossen ist.

Dieser Aufbau hat sich in der Praxis besonders bewährt. Der Raumbedarf an den zwei gegenüberliegenden Endabschnitten kann verringert und der vorhandene Platz optimal genutzt werden, da sowohl die Aufnahmen für jeweils zwei unterschiedliche Kapillaren sowie der Anschluss für jeweils einen doppelwandigen Schlauchabschnitt vorliegen. Auch in den mindestens zwei einander jeweils gegenüberliegenden Zwischenabschnitten kann der Raum optimal genutzt und der an den jeweiligen Endabschnitten angeschlossene doppelwandige Schlauchabschnitt durchgeführt werden.

Weiterhin bevorzugt ist bei diesen Weiterentwicklungen vorgesehen, dass zwischen den Endabschnitten sowie den Zwischenabschnitten auf einer Seite des Mehrfachvarianten-Endstücks und den Endabschnitten sowie den Zwischenabschnitten auf der gegenüberliegenden anderen Seite des Mehrfachvarianten-Endstücks jeweils Mittelstücke angeordnet sind, durch welche jeweils eine einzelne Kapillare geführt wird, die von dem Temperierkanal des Mehrfachvarianten-Endstücks umgeben ist.

Durch die Mittelstücke können die einzelnen Kapillaren vor Beschädigungen und Umwelteinflüssen geschützt werden. Weiterhin kann die Einrichtung zum Leiten von Temperierfluid durch die Mittelstücke weiter stabilisiert werden.

Ebenso bevorzugt sind Weiterbildungen der oben beschriebenen Ausführungsformen der erfindungsgemäßen Überwachungsvorrichtung, bei denen der äußere Teilschlauch und der innere Teilschlauch des doppelwandigen Schlauchabschnitts unterschiedlich weit in das Endstück eingeführt sind, vorzugsweise der innere Teilschlauch auf einer größeren Länge als der äußere Teilschlauch.

Auf diese Weise kann die entsprechende Kapillare, die in den inneren Teilschlauch eingeführt ist, besonders einfach gegen den äußeren Teilschlauch und das Temperierfluid, welches zwischen dem äußeren Teilschlauch und dem inneren Teilschlauch hindurchgeführt wird, abgedichtet werden. Außerdem kann das Temperierfluid unkompliziert in den Zwischenraum zwischen dem inneren Teilschlauch und dem äußeren Teilschlauch geleitet werden.

Bei einer weiteren, besonders bevorzugten Klasse von Ausführungsformen der erfindungsgemäßen Überwachungsvorrichtung ist vorgesehen, dass die Transportkapillaren identisch dimensionierte Außen-Abmaße aufweisen. Hierdurch kann der Aufbau der Einrichtung zum Leiten von Temperierfluid einheitlich gestaltet und somit die Nutzung der erfindungsgemäßen Überwachungsvorrichtung erleichtert werden.

Ebenfalls bevorzugt sind Ausführungsformen, bei denen die Transportkapillaren aus chemisch inertem Kunststoff, vorzugsweise aus PTFE aufgebaut sind. Auf diese Weise kann sichergestellt werden, dass die Transportkapillaren nicht durch die im Reaktionsbehälter erzeugte Reaktionsflüssigkeit beschädigt werden oder sich Bestandteile aus den Transportkapillaren lösen, welche die erzeugte Reaktionsflüssigkeit verunreinigen und die durchgeführten Messungen unbrauchbar machen können.

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert.

Es zeigen:
- Fig. 1a: eine perspektivische Ansicht von schräg oben auf eine Einrichtung zum Leiten von Temperierfluid einer erfindungsgemäßen Überwachungsvorrichtung in einer ersten Ausführungsform mit Endstücken, die als Mehrfachvarianten zur Aufnahme von mehreren Einlass- oder Auslasstransportkapillare ausgebildet sind;
- Fig. 1b: eine perspektivische Ansicht auf eine Einrichtung zum Leiten von Temperierfluid einer erfindungsgemäßen Überwachungsvorrichtung in einer zweiten Ausführungsform mit Endstücken, die als eine Einfachvariante zur Aufnahme lediglich einer Einlass- oder Auslasstransportkapillare ausgebildet sind;
- Fig. 2: einen Ausschnitt eines schematischen Längsschnitts der Einrichtung zum Leiten von Temperierfluid von Fig. 1a in der dort dargestellten Ebene A;
- Fig. 3: einen Ausschnitt eines schematischen Längsschnitts der Einrichtung zum Leiten von Temperierfluid von Fig. 1a in der dort dargestellten, zur Ebene A senkrechten Ebene B; und
- Fig. 4: einen schematischen Messaufbau zur Durchführung einer NMR-Messung mit einem NMR-Spektrometer unter Einsatz der erfindungsgemäßen Überwachungsvorrichtung.

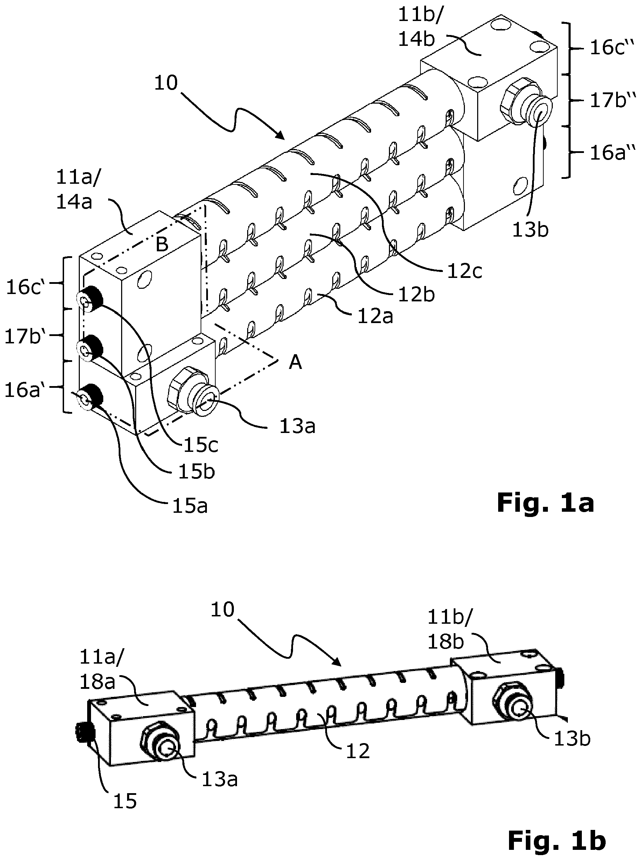

In **Fig. 1a** ist eine perspektivische Ansicht auf eine **Einrichtung 10** zum Leiten von Temperierfluid um Einlass- und Auslasstransportkapillaren herum einer erfindungsgemäßen Überwachungsvorrichtung in einer ersten Ausführungsform gezeigt. Die Einrichtung 10 umfasst in der hier gezeigten Ausführungsform zwei **Endstücke 11a, 11b,** zwischen denen drei **Mittelstücke 12a, 12b, 12c** angeordnet sind. Weiterhin sind die beiden aufeinander senkrecht stehenden Schnittebenen A und B eingezeichnet.

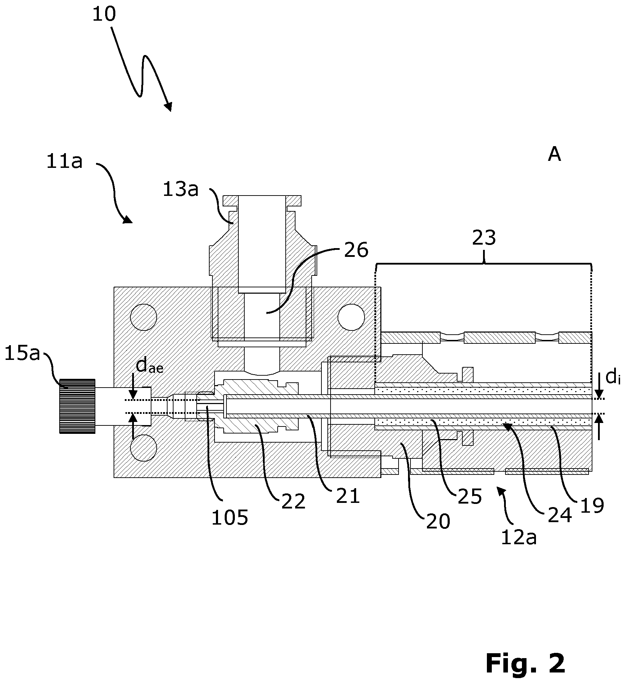

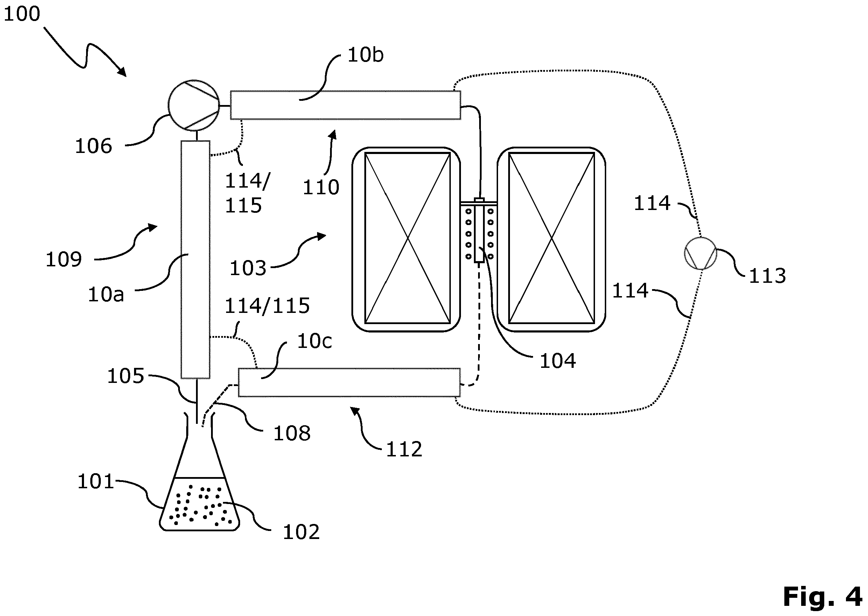

Das Endstück 11a weist hier einen **Fluidanschluss 13a** auf, das Endstück 11b einen **Fluidanschluss 13b.** Über die Fluidanschlüsse 13a, 13b wird die Einrichtung 10 zum Leiten von Temperierfluid mit einer Fluidpumpe verbunden, durch welche ein Temperierfluid in die Einrichtung 10 eingeleitet und wieder ausgeleitet werden kann (siehe hierzu Fig. 4). In der hier gezeigten Ausführungsform verläuft innerhalb der Einrichtung 10 ein Temperierkanal und ein doppelwandiger Schlauchabschnitt. Der Temperierkanal verläuft mäanderförmig innerhalb der Endstücke 11a, 11b, der doppelwandige Schlauchabschnitt verläuft in den Mittelstücken 12a, 12b, 12c zwischen den Endstücken 11a, 11b (siehe hierzu Fig. 2).

Durch den Temperierkanal und den doppelwandigen Schlauchabschnitt wird das Temperierfluid durch die Einrichtung 10 geleitet. Das Temperierfluid wird hier am Fluidanschluss 13a eingeleitet und über das Mittelstück 12a zum Endstück 11b geführt. Von dort wird das Temperierfluid über das Mittelstück 12b zum Endstück 11a zurückgeführt. Dann wird das Temperierfluid vom Endstück 11a über das Mittelstück 12c zum Fluidanschluss 13b geführt und aus der Einrichtung 10 ausgeleitet. Es kann eine gleichmäßige Temperierung in der gesamten Einrichtung 10 erreicht werden.

Die Endstücke 11a, 11b in Fig. 1a sind als **Mehrfachvarianten ("Mehrfachvarianten-Endstücke") 14a, 14b** ausgebildet, mit denen mehrere Einlass- oder Auslasstransportkapillaren aufgenommen werden können. In der hier gezeigten Ausführungsform sind keine Transportkapillaren in die Mehrfachvarianten-Endstücke 14a, 14b eingeführt. In weiteren, nicht gezeigten Ausführungsformen ist es jedoch möglich, dass eine, zwei oder drei Transportkapillaren in die Mehrfachvarianten-Endstücke 14a, 14b eingeführt sind. Beispielsweise können zwei Einlasstransportkapillaren mit unterschiedlichen Reaktionsflüssigkeiten und eine Auslasstransportkapillare zum Abführen der Reaktionsflüssigkeiten in die Mehrfachvarianten-Endstücke 14a, 14b eingeführt sein.

Weiterhin weisen die Endstücke 11a, 11b in der hier gezeigten Ausführungsform drei **Kapillaraufnahmen 15a, 15b, 15c** auf. Die Kapillaraufnahmen 15a, 15b, 15c sind mit Durchführungen verbunden, die durch die Endstücke 11a, 11b und die Mittelstücke 12a, 12b, 12c führen (nicht näher dargestellt).

Das Mehrfachvarianten-Endstück 14a weist hier zwei einander gegenüberliegende **Endabschnitte 16a', 16c'** und einen **Zwischenabschnitt 17b'** auf, das Mehrfachvarianten-Endstück 14b zwei einander gegenüberliegende **Endabschnitte 16a", 16c"** und einen **Zwischenabschnitt 17b".** Die Endabschnitte 16a`, 16a" umfassen den Fluidanschluss 13a, die Kapillaraufnahme 15a sowie das Mittelstück 12a. Die Endabschnitte 16c', 16c" umfassen den Fluidanschluss 13b, die Kapillaraufnahme 15c sowie das Mittelstück 12c. Die Zwischenabschnitte 17b`, 17b" umfassen die Kapillaraufnahme 15b sowie das Mittelstück 12b. Der Endabschnitte 16a" ist mit dem Zwischenabschnitt 17b" verbunden und der Endabschnitt 17c' ist mit den Zwischenabschnitten 17b' verbunden.

Die beiden Endstücke 11a, 11b sind in der hier gezeigten Ausführungsform mit jeweils zwei quaderförmigen Bauelementen ausgebildet. Die drei Mittelstücke 12a, 12b, 12c sind mit zylinderförmigen Bauelementen ausgebildet.

In **Fig. 1b** ist eine perspektivische Ansicht auf eine Einrichtung 10 zum Leiten von Temperierfluid um Einlass- und Auslasstransportkapillaren herum einer erfindungsgemäßen Überwachungsvorrichtung in einer zweiten Ausführungsform gezeigt. Die Einrichtung 10 umfasst in der hier gezeigten Ausführungsform zwei Endstücke 11a, 11b, zwischen denen ein **Mittelstück 12** angeordnet ist.

Das Endstück 11a weist hier den Fluidanschluss 13a auf, das Endstück 11b weist den Fluidanschluss 13b auf. Über die Fluidanschlüsse 13a, 13b wird die Einrichtung 10 zum Leiten von Temperierfluid mit der Fluidpumpe verbunden, durch welche ein Temperierfluid in die Einrichtung 10 eingeleitet und wieder ausgeleitet werden kann (siehe hierzu Fig. 4). Der Temperierkanal verläuft innerhalb der Endstücke 11a, 11b, der doppelwandige Schlauchabschnitt verläuft im Mittelstück 12b zwischen den Endstücken 11a, 11b (vergleiche hierzu Fig. 2).

Durch den Temperierkanal und den doppelwandigen Schlauchabschnitt wird das Temperierfluid durch die Einrichtung 10 geleitet. Das Temperierfluid wird am Endstück 11a am Fluidanschluss 13a zugeführt und wird über das Mittelstück 12 zum Fluidanschluss 13b an Endstück 11b geleitet. Hierdurch kann eine gleichmäßige Temperierung in der Einrichtung 10 erreicht werden.

Die Endstücke 11a, 11b sind hier als **Einfachvarianten ("Einfachvarianten-Endstücke") 18a, 18b** ausgebildet, mit denen eine einzige Einlass- oder Auslasstransportkapillare aufgenommen werden kann. In der hier gezeigten Ausführungsform sind allerdings keine Transportkapillaren in die Einfachvarianten-Endstücke 18a, 18b eingeführt.

Weiterhin weisen die Endstücke 11a, 11b in der in Fig. 1b gezeigten Ausführungsform **Kapillaraufnahmen 15** auf. Die Kapillaraufnahmen 15 sind mit einer Durchführung verbunden, die durch die Endstücke 11a, 11b und das Mittelstück 12 führt (nicht näher dargestellt).

Die beiden Endstücke 11a, 11b sind in der hier dargestellten Ausführungsform mit jeweils einem quaderförmigen Bauelement und das Mittelstück 12 als zylinderförmiges Bauelement ausgebildet.

**Fig. 2** zeigt einen Ausschnitt eines schematischen Längsschnitts der Einrichtung 10 von Fig. 1a in der dortigen Ebene A. Der Längsschnitt zeigt einen Teil des Endstücks 11a und einen Teil des Mittelstücks 12a.

In der hier dargestellten Ausführungsform ist zentral im Mittelstück 12a ein **äußerer Teilschlauch 19** angeordnet, der minimal in das Endstück 11a hineinragt und der in eine **äußere Dichthülse 20** mündet. Weiterhin verläuft zentral im Mittelstück 12a innerhalb des äußeren Teilschlauchs 19 ein **innerer Teilschlauch 21.** Der innere Teilschlauch 21 reicht axial weit über die Hälfte in das Endstück 11a hinein und mündet in einer **inneren Dichthülse 22.** Im Mittelstück 12a ist hier der innere Teilschlauch 21 in den äußeren Teilschlauch 19 verschachtelt angeordnet. Der innere Teilschlauch 21 ragt dabei axial deutlich über den äußeren Teilschlauch 19 hinaus.

Der äußere Teilschlauch 19 ist radial geschlossen und hat eine zylindrische Form, ebenso der innere Teilschlauch 21. In der hier gezeigten Ausführungsform hat der innere Teilschlauch 21 einen **Innendurchmesser dᵢ** von in der Regel ungefähr 0,16 cm. Der innere Teilschlauch 21 ist konzentrisch zum äußeren Teilschlauch 19 angeordnet.

Im Bereich der Überlappung des äußeren Teilschlauchs 19 und des inneren Teilschlauchs 21, hier also im Mittelstück 12a und minimal im Endstück 11a, bilden der äußere Teilschlauch 19 und der innere Teilschlauch 21 den doppelwandigen **Schlauchabschnitt 23** aus. Der doppelwandige Schlauchabschnitt 23 umfasst einen **Zwischenbereich 24,** durch welchen das **Temperierfluid 25** hindurchgeleitet wird. Der doppelwandige Schlauchabschnitt 23 ist mit dem **Temperierkanal 26** verbunden.

In der hier gezeigten Ausführungsform wurde eine zylindrisch ausgeformte **Einlasstransportkapillare 105** über die Kapillaraufnahme 15a am Endstück 11a in den inneren Teilschlauch 21 eingeführt. Der innere Teilschlauch 21 ist geometrisch auf die zylindrisch ausgeformte Einlasstransportkapillare 105 angepasst. Zum leichteren Einführen (und späteren Entfernen) der Einlasstransportkapillare 105 ist der innere Teilschlauch 21 aus einem Material mit Gleitwerkstoffen mit einem Reibungskoeffizienten von µ < 0,05 gefertigt. Alternativ kann der innere Teilschlauch 21 auch aus einem dehnbaren Material aufgebaut sein. In der hier gezeigten Ausführungsform ist die Einlasstransportkapillare 105 aus PTFE gefertigt. Durch diesen chemisch inerten Kunststoff kann sichergestellt werden, dass eine durch die Einlasstransportkapillare 105 geleitete Reaktionsflüssigkeit die Einlasstransportkapillare 105 nicht angreift und beispielsweise für ein Leck sorgt.

Ein **Außendurchmesser dₐₑ** der Einlasstransportkapillare 105 ist hier ungefähr 0,16 cm. Der Außendurchmesser dₐₑ der Einlasstransportkapillare 105 und der Innendurchmesser dᵢ des inneren Teilschlauchs 21 sind hier also ungefähr gleich groß. Hierdurch liegt die Einlasstransportkapillare 105 bündig am inneren Teilschlauch 21 an, wodurch zum einen eine gute Temperierung erreicht werden kann, wenn im Zwischenbereich 24 Temperierfluid 25 fließt, und zum anderen eine stabile Anordnung der Einlasstransportkapillare 105 im inneren Teilschlauch 21 erreicht werden kann. In einer weiteren, nicht gezeigten Ausführungsform kann der Innendurchmesser dᵢ des inneren Teilschlauchs 21 größer sein als der Außendurchmesser dₐ der Einlasstransportkapillare 105

Zur Temperierung der eingeführten Einlasstransportkapillare 105 und der in ihr transportierten Reaktionsflüssigkeit wird über den Fluidanschluss 13a das Temperierfluid 25 in die Einrichtung 10 eingeleitet. Von dort wird es dann über den Temperierkanal 26 in den Zwischenbereich 24 des doppelwandigen Schlauchabschnitts 23 weitergeleitet. Anschließend wird das Temperierfluid 25 über den Fluidanschluss 13b ausgeleitet (nicht näher dargestellt).

Der doppelwandige Schlauchabschnitt 23 liegt in der hier gezeigten Ausführungsform als eigenständige, austauschbare Einheit vor und ist als Baukasten-System aufgebaut. Weiterhin liegt der doppelwandige Schlauchabschnitt 23 hier als abgeschlossen Einheit mit einer Länge von in der Regel 2 m vor (in der Figur sind lediglich die ersten 10 cm des doppelwandigen Schlauchabschnitts 23 angedeutet).

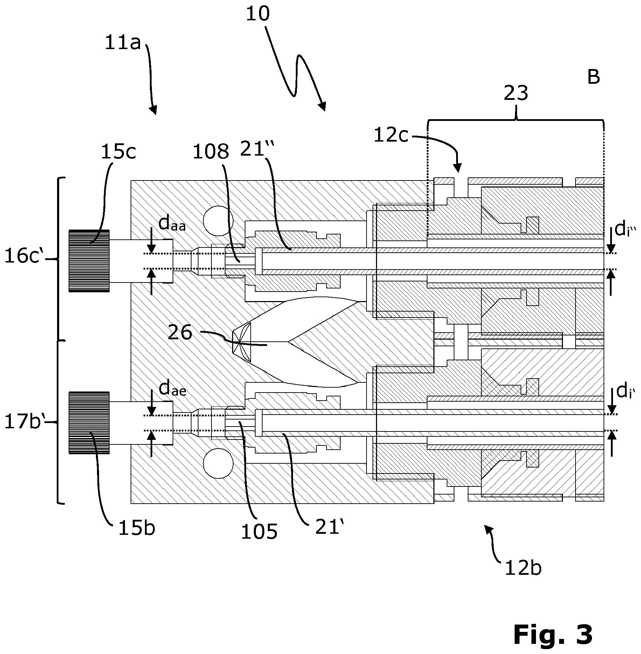

**Fig. 3** zeigt einen Ausschnitt eines schematischen Längsschnitts der Einrichtung 10 von Fig. 1a in der dortigen Ebene B, welche senkrecht zur Ebene A steht. Der Längsschnitt zeigt einen Teil des Endstücks 11a, nämlich den Endabschnitt 16c' und den Zwischenabschnitt 17b' und einen Teil der Mittelstücke 12b, 12c. Die Ausgestaltung des doppelwandigen Schlauchabschnitts 23 in der hier gezeigten Fig. 3 ist identisch zur Ausgestaltung des doppelwandigen Schlauchabschnitts 23 in Fig. 2.

In der in Fig. 3 dargestellten Ausführungsform wurde die zylindrisch ausgeformte Einlasstransportkapillare 105 über die Kapillaraufnahme 15b am Endstück 11a in den **inneren Teilschlauch 21'** eingeführt, und eine zylindrisch ausgeformte **Auslasstransportkapillare 108** wurde über die Kapillaraufnahme 15c am Endstück 11a in den **inneren Teilschlauch 21"** eingeführt. Der innere Teilschlauch 21' ist geometrisch auf die zylindrisch ausgeformte Einlasstransportkapillare 105 angepasst und der innere Teilschlauch 21" ist geometrisch auf die zylindrisch ausgeformte Auslasstransportkapillare 108 angepasst.

Zum leichteren Einführen (und späteren Entfernen) der Transportkapillaren 105, 108 sind die inneren Teilschläuche 21', 21" aus einem Material mit Gleitwerkstoffen mit einem Reibungskoeffizienten von µ < 0,05 gefertigt. In der hier gezeigten Ausführungsform sind die Transportkapillaren 105, 108 aus PTFE gefertigt.

Der Außendurchmesser dₐₑ der Einlasstransportkapillare 105 beträgt hier in der Regel ungefähr 0,16 cm, ein **Außendurchmesser dₐₐ** der Auslasstransportkapillare 108 beträgt ebenfalls ungefähr 0,16 cm. Die Transportkapillaren 105, 108 weisen hier also identisch dimensionierte Außen-Abmaße auf. Die Außendurchmesser dₐₐ, dₐₑ der Transportkapillaren 105, 108 und die **Innendurchmesser d_{i'}, d_{i"}** der inneren Teilschläuche 21', 21" mit jeweils 0,16 cm sind ungefähr gleich groß. Hierdurch liegen die Transportkapillaren 105, 108 bündig an den inneren Teilschläuchen 21', 21" an.

Zur gleichmäßigen und gleichzeitigen Temperierung der eingeführten Transportkapillaren 105, 108 und der in ihnen transportierten Reaktionsflüssigkeiten sind die Teile des doppelwandige Schlauchabschnitt 23 über den Temperierkanal 26 miteinander verbunden.

**Fig. 4** zeigt einen schematischen Messaufbau zur Durchführung einer NMR-Messung mit einer erfindungsgemäßen **Überwachungsvorrichtung 100.** Diese weist erfindungsgemäß einen geschlossenen Temperierkreislauf für das Temperierfluid 25 auf, welcher geometrisch derart ausgestaltet ist, dass das Temperierfluid 25 in jedem räumlichen Bereich dieses Temperierkreislaufs immer nur in eine vorgegebene Richtung fließt und keine gegenläufige Strömung des Temperierfluids 25 in unmittelbarer Nachbarschaft des räumlichen Bereichs auftritt.

In einem **Reaktionsbehälter 101** wird eine **Reaktionsflüssigkeit 102** erzeugt. Diese Reaktionsflüssigkeit 102 wird zum **NMR-Spektrometer 103** in eine darin befindliche **NMR-Probensonde 104** geleitet, um dort chemische Reaktionen in Echtzeit mittels NMR-Spektroskopie zu vermessen.

Die Reaktionsflüssigkeit 102 wird über die Einlasstransportkapillare 105 (hier als durchgezogene Linie dargestellt) zur Probensonde 104 transportiert. Hierzu wird die Reaktionsflüssigkeit 102 durch eine **Pumpeinrichtung 106** weiter in die NMR-Probensonde 104 geleitet. Über die Auslasstransportkapillare 108 (hier als gestrichelte Linie dargestellt) wird die vermessene Reaktionsflüssigkeit 102 in den Reaktionsbehälter 101 geleitet.

Zur gleichmäßigen Temperierung der Reaktionsflüssigkeit 101 über den gesamten Messaufbau verlaufen die Transportkapillaren 105, 108 in drei **Abschnitten 109, 110, 112** jeweils durch die **Einrichtungen 10a, 10b, 10c** zum Leiten von Temperierfluid. In den Abschnitten 109 und 110 verläuft nur die Einlasstransportkapillare 105 durch die Einrichtungen 10a, 10b. In Abschnitt 112 verläuft nur die Auslasstransportkapillare 108 durch die Einrichtung 10c.

Das Temperierfluid wird durch eine **Fluidpumpe 113** in die Einrichtungen 10a, 10b, 10c gepumpt (geleitet). Die Fluidpumpe 113 und die Einrichtungen 10a, 10b, 10c sind über **Fluidleitungen 114** (im hier gezeigten Beispiel vier Fluidleitungen 114, die als gepunktete Linien gezeigt sind) miteinander verbunden (die Fluidanschlüsse an den Einrichtungen 10a, 10b, 10c sind der Übersichtlichkeit halber nicht dargestellt). Im hier gezeigten Beispiel wird das Temperierfluid von der Fluidpumpe 113 im Uhrzeigersinn über die Fluidleitungen 114 zuerst in Einrichtung 10c, dann in Einrichtung 10a, von dort in Einrichtung 10b und von dort wiederum zurück zur Fluidpumpe 113 geführt. Es handelt sich hier also um einen geschlossenen Temperierkreislauf, wodurch eine gleichmäßige Temperierung erreicht werden kann. Man beachte im hier gezeigten Beispiel, dass der Reaktionsbehälter 101 und die Pumpeinrichtung 106 nicht über Fluidleitungen 114 mit der Fluidpumpe 113 verbunden sind. Die Fluidleitungen 114 werden als jeweils ein **Bypass 115** ausgebildet am Reaktionsbehälter 101 und an der Pumpeinrichtung 106 vorbeigeführt.

### Bezugszeichenliste:

- 10, 10a-10c: Einrichtung (zum Leiten von Temperierfluid)
- 11a, 11b: Endstück
- 12, 12a, 12b, 12c: Mittelstück
- 13a, 13b: Fluidanschluss
- 14a, 14b: Mehrfachvariante, Mehrfachvarianten-Endstück
- 15, 15a, 15b, 15c: Kapillaraufnahme
- 16a`, 16a": Endabschnitt (am unteren Ende)
- 16c`, 16c": Endabschnitt (am oberen Ende)
- 17b`, 17b": Zwischenabschnitt
- 18a, 18b: Einfachvariante, Einfachvarianten-Endstück
- 19: äußerer Teilschlauch
- 20: äußere Dichthülse
- 21, 21', 21": innerer Teilschlauch
- 22: innere Dichthülse
- 23: (doppelwandiger) Schlauchabschnitt
- 24: Zwischenbereich
- 25: Temperierfluid
- 26: Temperierkanal

- 100: Überwachungsvorrichtung
- 101: Reaktionsbehälter
- 102: Reaktionsflüssigkeit
- 103: NMR-Spektrometer
- 104: NMR-Probensonde
- 105: Einlasstransportkapillare
- 106: Pumpeinrichtung
- 108: Auslasstransportkapillare
- 109: Abschnitt (zwischen Reaktionsbehälter und Pumpeinrichtung)
- 110: Abschnitt (zwischen Pumpeinrichtung und NMR-Spektrometer)
- 112: Abschnitt (zwischen NMR-Spektrometer und Reaktionsbehälter)
- 113: Fluidpumpe
- 114: Fluidleitungen
- 115: Bypass

- dₐₐ: Außendurchmesser (der Auslasstransportkapillare)
- dₐₑ: Außendurchmesser (der Einlasstransportkapillare)
- dᵢ, d_{i'}, d_{i"}: Innendurchmesser (des inneren Teilschlauchs)

### Referenzliste

Für die Beurteilung der Patentfähigkeit in Betracht gezogene Publikationen:
[0] FOLEY, David A., et al. "NMR flow tube for online NMR reaction monitoring" Analytical chemistry, 2024, 86. Jg., Nr. 24, S.12008-12013
[1] DE 10 2015 206 030 B3 ≈ EP 3 076 197 B1 ≈ US 9,476,848 B1
[2] EP 2 407 796 B1 ≈ US 8,686,729 B2
[3] InsightMR, Bruker Corporation, Billerica, Massachusetts, USA

## Patentansprüche

1. Überwachungsvorrichtung (100) zum Durchführen einer Messung einer in einem Reaktionsbehälter (101) erzeugten Reaktionsflüssigkeit (102) in einem NMR-Spektrometer (103), insbesondere zur Kontrolle einer chemischen Reaktion mittels NMR-Spektroskopie, wobei die Überwachungsvorrichtung (100) mindestens folgende Bauteile aufweist:
eine hohle NMR-Probensonde (104) für die Aufnahme der im NMR-Spektrometer (103) zu vermessenden Reaktionsflüssigkeit (102);
eine Einlasstransportkapillare (105) zur Aufnahme der Reaktionsflüssigkeit (102) aus dem Reaktionsbehälter (101) und für den Transport der Reaktionsflüssigkeit (102) von dem Reaktionsbehälter (101) über eine Pumpeinrichtung (106) hin zur Probensonde (104);
eine Auslasstransportkapillare (108) für den Rücktransport der Reaktionsflüssigkeit (102) von der Probensonde (104) zum Reaktionsbehälter (101);
eine Einrichtung (10, 10a - 10c), die zum Leiten von Temperierfluid (25) um die Einlass- und Auslasstransportkapillaren (105; 108) herum ausgestaltet ist,
wobei die Einrichtung (10, 10a - 10c) zum Leiten von Temperierfluid (25) um die Einlass- und Auslasstransportkapillaren (105; 108) herum Schlauchabschnitte (23) aufweist, die jeweils doppelwandig aus zwei ineinander verschachtelt angeordneten, radial jeweils geschlossenen Teilschläuchen (19; 21, 21', 21") mit einem äußeren Teilschlauch (19) und
einem inneren Teilschlauch (21, 21', 21") aufgebaut sind, wobei zwischen dem äußeren und dem inneren Teilschlauch (19; 21, 21', 21") das Temperierfluid (25) fließt und radial innerhalb des inneren Teilschlauchs (21, 21', 21") die Einlasstransportkapillare (105) oder die Auslasstransportkapillare (108) angeordnet ist,
und wobei die Überwachungsvorrichtung (100) einen geschlossenen Temperierkreislauf für das Temperierfluid (25) aufweist,
**dadurch gekennzeichnet,**
**dass** der Temperierkreislauf für das Temperierfluid (25) geometrisch derart ausgestaltet ist, dass im vorgesehenen Betrieb das Temperierfluid (25) in jedem räumlichen Bereich des Temperierkreislaufs immer nur in eine vorgegebene Richtung fließt und keine gegenläufige Strömung des Temperierfluids (25) in unmittelbarer Nachbarschaft des räumlichen Bereichs auftritt.

2. Überwachungsvorrichtung nach Anspruch 1, **dadurch gekennzeichnet, dass** die inneren Teilschläuche (21, 21', 21") konzentrisch zu den äußeren Teilschläuchen (19) angeordnet sind.

3. Überwachungsvorrichtung nach einem der vorhergehenden Ansprüche, **dadurch gekennzeichnet, dass** die inneren Teilschläuche (21, 21', 21") geometrisch derart ausgebildet sind, dass die Einlasstransportkapillare (105) und die Auslasstransportkapillare (108) in die inneren Teilschläuche (21, 21', 21") eingeführt und auch wieder aus ihnen herausgezogen werden können.

4. Überwachungsvorrichtung nach Anspruch 3, **dadurch gekennzeichnet, dass** die Innendurchmesser (dᵢ, d_{i'}, d_{i"}) der inneren Teilschläuche (21, 21', 21") größer oder gleich den Außendurchmessern (dₐₑ; dₐₐ) der entsprechenden Einlasstransportkapillare (105) beziehungsweise der entsprechenden Auslasstransportkapillare (108) gestaltet sind.

5. Überwachungsvorrichtung nach Anspruch 4, **dadurch gekennzeichnet, dass** zumindest die inneren Teilschläuche (21, 21', 21") aus einem Material mit Gleitwerkstoffen mit Reibungskoeffizienten µ ≤ 1, vorzugsweise µ ≤ 0,1, insbesondere µ ≤ 0,05, und/oder einem dehnbaren Material aufgebaut sind.

6. Überwachungsvorrichtung nach einem der vorhergehenden Ansprüche, **dadurch gekennzeichnet, dass** die doppelwandigen Schlauchabschnitte (23) der Einrichtung (10, 10a - 10c) zum Leiten von Temperierfluid (25) um die Einlass- und Auslasstransportkapillaren (105; 108) herum als Baukasten-System aufgebaut sind, welches auf verschiedene Benutzer-Anforderungen, NMR-Spektrometer (103) und Umgebungen adaptiert werden kann, und in welchem die doppelwandigen Schlauchabschnitte (23) als jeweils eigenständige, insbesondere austauschbare Einheiten vorhanden sind.

7. Überwachungsvorrichtung nach Anspruch 6, **dadurch gekennzeichnet, dass** die doppelwandigen Schlauchabschnitte (23) als abgeschlossene Einheiten einer jeweils vorbestimmten Länge, insbesondere mit einer Länge von 2m, ausgeführt sind.

8. Überwachungsvorrichtung nach einem der vorhergehenden Ansprüche, **dadurch gekennzeichnet, dass** die Einrichtung (10, 10a - 10c) zum Leiten von Temperierfluid (25) um die Einlass- und Auslasstransportkapillaren (105; 108) herum Endstücke (11a, 11b) zum Anschluss der doppelwandigen Schlauchabschnitte (23) an eine Fluidpumpe (113) umfasst.

9. Überwachungsvorrichtung nach Anspruch 8, **dadurch gekennzeichnet, dass** zumindest ein Teil der Endstücke (11a, 11b) als Mehrfachvarianten (14a, 14b) zur gleichzeitigen Aufnahme von mehreren Einlass- oder Auslasstransportkapillaren (105; 108) für unterschiedliche Reaktionsflüssigkeiten (102) ausgebildet sind.

10. Überwachungsvorrichtung nach Anspruch 9, **dadurch gekennzeichnet, dass** das Mehrfachvarianten-Endstück (14a, 14b) so ausgebildet ist, dass es mehrere, vorzugsweise drei, Einlass- oder Auslasstransportkapillaren (105; 108) aufnehmen kann, jedoch nur einen doppelwandigen Schlauchabschnitt (23), mit dem sämtliche aufgenommenen Kapillaren (105; 108) über einen mäanderförmig durch das Mehrfachvarianten-Endstück (14a, 14b) verlaufenden Temperierkanal (26) gleichzeitig temperiert werden können.

11. Überwachungsvorrichtung nach Anspruch 10, **dadurch gekennzeichnet, dass** das Mehrfachvarianten-Endstück (14a, 14b) zwei einander gegenüberliegende Endabschnitte (16a', 16a", 16c', 16c") aufweist, die zur Aufnahme von jeweils zwei unterschiedlichen Kapillaren (105; 108) sowie zum Anschluss jeweils eines doppelwandigen Schlauchabschnitts (23) ausgebildet sind, dass mindestens zwei einander jeweils gegenüberliegende Zwischenabschnitte (17b`, 17b") vorgesehen sind, in welche nur jeweils eine Kapillare (105, 108) eingeführt werden kann, und dass die Endabschnitte (16a", 16c') mit den Zwischenabschnitten (17b', 17b") derart verbunden sind, dass der an den jeweiligen Endabschnitt (16a", 16c') angeschlossene doppelwandige Schlauchabschnitt (23) an einem dem Endabschnitt (16a", 16c') unmittelbar benachbart angeordneten Zwischenabschnitt (17b', 17b") angeschlossen ist.

12. Überwachungsvorrichtung nach Anspruch 11, **dadurch gekennzeichnet, dass** zwischen den Endabschnitten (16a', 16a", 16c', 16c") sowie den Zwischenabschnitten (17b', 17b") auf einer Seite des Mehrfachvarianten-Endstücks (14a, 14b) und den Endabschnitten (16a', 16a", 16c', 16c") sowie den Zwischenabschnitten (17b', 17b") auf der gegenüberliegenden anderen Seite des Mehrfachvarianten-Endstücks (14a, 14b) jeweils Mittelstücke (12; 12a, 12b, 12c) angeordnet sind, durch welche jeweils eine einzelne Kapillare (105; 108) geführt wird, die von dem Temperierkanal (26) des Mehrfachvarianten-Endstücks (14a, 14b) umgeben ist.

13. Überwachungsvorrichtung nach einem der Ansprüche 8 bis 12, **dadurch gekennzeichnet, dass** der äußere Teilschlauch (19) und der innere Teilschlauch (21, 21', 21") des doppelwandigen Schlauchabschnitts (23) unterschiedlich weit in das Endstück (11a, 11b) eingeführt sind, vorzugsweise der innere Teilschlauch (21, 21', 21") auf einer größeren Länge als der äußere Teilschlauch (19).

14. Überwachungsvorrichtung nach einem der vorhergehenden Ansprüche, **dadurch gekennzeichnet, dass** die Transportkapillaren (105; 108) identisch dimensionierte Außen-Abmaße aufweisen.

15. Überwachungsvorrichtung nach einem der vorhergehenden Ansprüche, **dadurch gekennzeichnet, dass** die Transportkapillaren (105; 108) aus chemisch inertem Kunststoff, vorzugsweise aus PTFE aufgebaut sind.

## Claims

1. Monitoring device (100) for performing a measurement of a reaction liquid (102) produced in a reaction tank (101) in an NMR spectrometer (103), in particular for controlling a chemical reaction by means of NMR spectroscopy, the monitoring device (100) having at least the following components:
a hollow NMR sample probe (104) for receiving the reaction liquid (102) to be measured in the NMR spectrometer (103);
an inlet transport capillary (105) for receiving the reaction liquid (102) from the reaction tank (101) and for transporting the reaction liquid (102) from the reaction tank (101) via a pump device (106) toward the sample probe (104);
an outlet transport capillary (108) for the return transport of the reaction liquid (102) from the sample probe (104) to the reaction tank (101);
a device (10, 10a - 10c) equipped for conducting temperature-control fluid (25) around the inlet and outlet transport capillaries (105; 108),
the device (10, 10a - 10c) for conducting temperature-control fluid (25) around the inlet and outlet transport capillaries (105; 108) comprising tube portions (23), each of which is constructed in double-walled fashion from two radially closed partial tubes (19; 21, 21', 21") arranged nested in one another, comprising an outer partial tube (19) and an inner partial tube (21, 21', 21"), the temperature-control fluid (25) flowing between the outer and the inner partial tube (19; 21, 21', 21") and the inlet transport capillary (105) or the outlet transport capillary (108) being arranged radially within the inner partial tube (21, 21', 21"),
and wherein the monitoring device (100) has a closed temperature-control circuit for the temperature-control fluid (25),
**characterized in that**
the temperature-control circuit for the temperature-control fluid (25) is geometrically designed such that in the intended operation the temperature-control fluid (25) always flows only in a predetermined direction in each spatial region of the temperature-control circuit and no opposing flow of the temperature-control fluid (25) in the immediate vicinity of the spatial region occurs.

2. Monitoring device according to claim 1, **characterized in that** the inner partial tubes (21, 21', 21") are arranged concentrically with respect to the outer partial tubes (19).

3. Monitoring device according to either of the preceding claims, **characterized in that** the inner partial tubes (21, 21', 21") are geometrically designed such that the inlet transport capillary (105) and the outlet transport capillary (108) can be inserted into the inner partial tubes (21, 21', 21") and pulled out of these again.

4. Monitoring device according to claim 3, **characterized in that** the inner diameters (dᵢ, d_{i'}, d_{i"}) of the inner partial tubes (21, 21', 21") are designed so as to be larger than or equal to the outer diameters (dₐₑ; dₐₐ) of the corresponding inlet transport capillary (105) or the corresponding outlet transport capillary (108).

5. Monitoring device according to claim 4, **characterized in that** at least the inner partial tubes (21, 21', 21") are made of a material comprising sliding materials having coefficients of friction µ ≤ 1, preferably µ ≤ 0.1, in particular µ ≤ 0.05, and/or an expandable material.

6. Monitoring device according to any of the preceding claims, **characterized in that** the double-walled tube portions (23) of the device (10, 10a - 10c) for conducting temperature-control fluid (25) around the inlet and outlet transport capillaries (105; 108) are designed as a kit system, which can be adapted to different user requirements, NMR spectrometers (103) and environments, and in which the double-walled tube portions (23) are present as independent, in particular replaceable, units in each case.

7. Monitoring device according to claim 6, **characterized in that** the double-walled tube portions (23) are designed as closed units of a predetermined length in each case, in particular of a length of 2 m.

8. Monitoring device according to any of the preceding claims, **characterized in that** the device (10, 10a - 10c) for conducting temperature-control fluid (25) around the inlet and outlet transport capillaries (105; 108) comprises end pieces (11a, 11b) for connecting the double-walled tube portions (23) to a fluid pump (113).

9. Monitoring device according to claim 8, **characterized in that** at least some of the end pieces (11a, 11b) are designed as multiple variants (14a, 14b) for simultaneously receiving a plurality of inlet or outlet transport capillaries (105; 108) for different reaction liquids (102).

10. Monitoring device according to claim 9, **characterized in that** the multiple-variant end piece (14a, 14b) is designed such that it can receive a plurality of, preferably three, inlet or outlet transport capillaries (105; 108), but only one double-walled tube portion (23), by means of which all the received capillaries (105; 108) can be temperature-controlled at the same time via a temperature-control channel (26) extending in a meandering manner through the multiple-variant end piece (14a, 14b).

11. Monitoring device according to claim 10, **characterized in that** the multiple-variant end piece (14a, 14b) has two mutually opposite end portions (16a', 16a", 16c', 16c") which are designed to receive two different capillaries (105; 108) in each case and for connection of a double-walled tube portion (23) in each case, in such a way that at least two mutually opposing intermediate portions (17b', 17b") are provided, into each of which just one capillary (105, 108) can be inserted in each case, and **in that** the end portions (16a", 16c') are connected to the intermediate portions (17b', 17b") in such a way that the double-walled tube portion (23) connected to the respective end portion (16a", 16c') is connected to an intermediate portion (17b', 17b") arranged directly adjacently to the end portion (16a", 16c').

12. Monitoring device according to claim 11, **characterized in that** central pieces (12; 12a, 12b, 12c) are arranged in each case between the end portions (16a', 16a", 16c', 16c") and the intermediate portions (17b', 17b") on one side of the multiple-variant end piece (14a, 14b), and the end portions (16a', 16a", 16c', 16c") and the intermediate portions (17b', 17b") on the opposite other side of the multiple-variant end piece (14a, 14b), through which central pieces a single capillary (105; 108) is guided in each case, which is surrounded by the temperature-control channel (26) of the multiple-variant end piece (14a, 14b).

13. Monitoring device according to any of claims 8 to 12, **characterized in that** the outer partial tube (19) and the inner partial tube (21, 21', 21") of the double-walled tube portion (23) are inserted into the end piece (11a, 11b) to different extents, the inner partial tube (21, 21', 21") preferably to a greater length than the outer partial tube (19).

14. Monitoring device according to any of the preceding claims, **characterized in that** the transport capillaries (105; 108) have identically dimensioned outer dimensions.

15. Monitoring device according to any of the preceding claims, **characterized in that** the transport capillaries (105; 108) are made of chemically inert plastics material, preferably of PTFE.

## Revendications

1. Dispositif de surveillance (100) dévolu à l'exécution d'une mesure d'un liquide réactionnel (102) engendré dans un récipient de réaction (101) d'un spectromètre RMN (103), notamment en vue du contrôle d'une réaction chimique par spectroscopie RMN, ledit dispositif de surveillance (100) étant au moins muni des composants structurels suivants :
une sonde creuse (104) d'échantillonnage RMN, conçue pour recevoir le liquide réactionnel (102) devant être mesuré dans le spectromètre RMN (103) ;
un capillaire de transport (105) d'entrée, affecté à la réception du liquide réactionnel (102) provenant du récipient de réaction (101) et au transport dudit liquide réactionnel (102) vers ladite sonde d'échantillonnage (104), à partir dudit récipient de réaction (101), par l'intermédiaire d'un agencement de pompage (106) ;
un capillaire de transport (108) de sortie, dédié au transport de retour dudit liquide réactionnel (102) vers ledit récipient de réaction (101), à partir de ladite sonde d'échantillonnage (104) ;
un système (10, 10a-10c) conçu pour guider du fluide d'équilibrage thermique (25) tout autour desdits capillaires de transport (105 ; 108) d'entrée et de sortie,
lequel système (10, 10a-10c), conçu pour guider du fluide d'équilibrage thermique (25) tout autour desdits capillaires de transport (105 ; 108) d'entrée et de sortie, est pourvu de tronçons de tuyau souple (23) présentant, à chaque fois, une réalisation à double paroi composée de deux tuyaux souples partiels (19 ; 21, 21', 21") respectivement fermés dans le sens radial et imbriqués l'un dans l'autre, comprenant un tuyau souple partiel (19) extérieur et un tuyau souple partiel (21, 21', 21") intérieur, sachant que ledit fluide d'équilibrage thermique (25) s'écoule entre lesdits tuyaux souples partiels (19 ; 21, 21', 21") extérieur et intérieur, et que ledit capillaire de transport (105) d'entrée ou ledit capillaire de transport (108) de sortie est logé radialement à l'intérieur dudit tuyau souple partiel (21, 21', 21") intérieur,
et sachant que ledit dispositif de surveillance (100) est doté d'un circuit fermé d'équilibrage de température, assigné audit fluide d'équilibrage thermique (25),
**caractérisé par le fait**
**que** le circuit d'équilibrage de température, assigné au fluide d'équilibrage thermique (25), est géométriquement organisé de façon telle que, lors du fonctionnement prévu, ledit fluide d'équilibrage thermique (25) s'écoule toujours uniquement dans une direction préétablie, dans chaque zone spatiale dudit circuit d'équilibrage de température, et qu'il n'advienne aucun écoulement dudit fluide d'équilibrage thermique (25) s'opérant en sens inverse au voisinage immédiat de ladite zone spatiale.

2. Dispositif de surveillance selon la revendication 1, **caractérisé par le fait que** les tuyaux souples partiels (21, 21', 21") intérieurs sont placés concentriquement aux tuyaux souples partiels (19) extérieurs.

3. Dispositif de surveillance selon l'une des revendications précédentes, **caractérisé par le fait que** les tuyaux souples partiels (21, 21', 21") intérieurs sont agencés géométriquement de telle sorte que les capillaires de transport (105) d'entrée et les capillaire de transport (108) de sortie puissent être introduits dans lesdits tuyaux souples partiels (21, 21', 21") intérieurs, et en être de nouveau extraits.

4. Dispositif de surveillance selon la revendication 3, **caractérisé par le fait que** les diamètres internes (dᵢ, d_{i'}, d_{i"}) des tuyaux souples partiels (21, 21', 21") intérieurs sont conçus supérieurs ou égaux aux diamètres externes (dₐₑ ; dₐₐ) des capillaires de transport d'entrée (105) correspondants, respectivement des capillaires de transport de sortie (108) correspondants.

5. Dispositif de surveillance selon la revendication 4, **caractérisé par le fait qu'**au moins les tuyaux souples partiels (21, 21', 21") intérieurs sont constitués d'un matériau à substances de glissement présentant des coefficients de frottement µ ≤ 1, de préférence µ ≤ 0,1, en particulier µ ≤ 0,05 ; et/ou d'un matériau extensible.

6. Dispositif de surveillance selon l'une des revendications précédentes, **caractérisé par le fait que** les tronçons de tuyau souple (23), à double paroi, du système (10, 10a-10c) conçu pour guider du fluide d'équilibrage thermique (25) tout autour des capillaires de transport (105 ; 108) d'entrée et de sortie, sont structurellement organisés sous la forme d'un système modulaire qui peut être adapté à différents types d'exigences d'utilisateurs, de spectromètres RMN (103) et d'environnements, et dans lequel lesdits tronçons de tuyau souple (23) à double paroi sont présents, à chaque fois, en tant qu'unités autonomes notamment remplaçables.

7. Dispositif de surveillance selon la revendication 6, **caractérisé par le fait que** les tronçons de tuyau souple (23), à double paroi, sont réalisés en tant qu'unités closes de longueur respectivement prédéterminée, présentant notamment une longueur de 2 m.

8. Dispositif de surveillance selon l'une des revendications précédentes, **caractérisé par le fait que** le système (10, 10a-10c), conçu pour guider du fluide d'équilibrage thermique (25) tout autour des capillaires de transport (105 ; 108) d'entrée et de sortie, inclut des pièces d'extrémité (11a, 11b) conçues pour raccorder les tronçons de tuyau souple (23), à double paroi, à une pompe à fluide (113).

9. Dispositif de surveillance selon la revendication 8, **caractérisé par le fait qu'**au moins une partie des pièces d'extrémité (11a, 11b) est réalisée sous la forme de variantes multiples (14a, 14b) conçues pour recevoir, en simultanéité, plusieurs capillaires de transport (105 ; 108) d'entrée ou de sortie dédiés à différents liquides réactionnels (102).

10. Dispositif de surveillance selon la revendication 9, **caractérisé par le fait que** la pièce d'extrémité à variante multiple (14a, 14b) est conçue de façon telle qu'elle puisse recevoir plusieurs capillaires de transport (105 ; 108) d'entrée ou de sortie, préférentiellement au nombre de trois, mais toutefois uniquement un tronçon de tuyau souple (23), à double paroi, à l'aide duquel tous les capillaires reçus (105 ; 108) peuvent être équilibrés thermiquement, en simultanéité, par l'intermédiaire d'un canal (26) d'équilibrage de température qui parcourt, sous forme de méandres, ladite pièce d'extrémité à variante multiple (14a, 14b).

11. Dispositif de surveillance selon la revendication 10, **caractérisé par le fait que** la pièce d'extrémité à variante multiple (14a, 14b) comporte deux régions extrêmes (16a', 16a", 16c', 16c") pointant à l'opposé l'une de l'autre, qui sont affectées à la réception de deux capillaires (105 ; 108) respectivement différents, ainsi qu'au raccordement d'un tronçon de tuyau souple (23) respectif, à double paroi ; par la présence d'au moins deux régions intermédiaires (17b', 17b") pointant respectivement à l'opposé l'une de l'autre, dans lesquelles seul un capillaire (105, 108) peut être introduit à chaque fois ; et **par le fait que** les régions extrêmes (16a", 16c') sont reliées aux régions intermédiaires (17b', 17b") de façon telle que le tronçon de tuyau souple (23) à double paroi, raccordé à la région extrême (16a", 16c') considérée, soit raccordé à une région intermédiaire (17b', 17b") occupant un emplacement directement voisin de ladite région extrême (16a", 16c').

12. Dispositif de surveillance selon la revendication 11, **caractérisé par le fait que** des pièces intercalaires (12 ; 12a, 12b, 12c), assurant le guidage respectif d'un capillaire individuel (105 ; 108) entouré par le canal (26) d'équilibrage de température de la pièce d'extrémité à variante multiple (14a, 14b), sont respectivement interposées entre les régions extrêmes (16a', 16a", 16c', 16c"), ainsi qu'entre les régions intermédiaires (17b', 17b"), sur un côté de ladite pièce d'extrémité à variante multiple (14a, 14b), de même qu'entre lesdites régions extrêmes (16a', 16a", 16c', 16c"), ainsi qu'entre lesdites régions intermédiaires (17b', 17b"), sur l'autre côté opposé de ladite pièce d'extrémité à variante multiple (14a, 14b).

13. Dispositif de surveillance selon l'une des revendications 8 à 12, **caractérisé par le fait que** le tuyau souple partiel (19) extérieur, et le tuyau souple partiel (21, 21', 21") intérieur du tronçon de tuyau souple (23) à double paroi, sont introduits différemment loin dans la pièce d'extrémité (11a, 11b), de préférence, concernant ledit tuyau souple partiel (21, 21', 21") intérieur, sur une plus grande longueur que ledit tuyau souple partiel (19) extérieur.

14. Dispositif de surveillance selon l'une des revendications précédentes, **caractérisé par le fait que** les capillaires de transport (105 ; 108) présentent des cotes extérieures de dimensionnements identiques.

15. Dispositif de surveillance selon l'une des revendications précédentes, **caractérisé par le fait que** les capillaires de transport (105 ; 108) consistent en une matière plastique chimiquement inerte, de préférence en du PTFE.
